(19)

Europäisches
Patentamt
European
Patent Office
Office européen
des brevets

(11)  **EP 2 768 136 A1**

(12)  **EUROPEAN PATENT APPLICATION**

(43) Date of publication:
**20.08.2014  Bulletin 2014/34**

(51) Int Cl.:
**H03F 3/217** (2006.01)

(21) Application number: **13305168.0**

(22) Date of filing: **13.02.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ST-Ericsson SA
1228 Plan-les-Ouates (CH)**

(72) Inventors:
• **Branca, Xavier
38000 Grenoble (FR)**
• **Chesneau, David
38500 Voiron (FR)**
• **Nagari, Angelo
38000 Grenoble (FR)**

(74) Representative: **Cabinet Plasseraud
52, rue de la Victoire
75440 Paris Cedex 09 (FR)**

(54)  **Audio amplifier**

(57)     An audio amplifier for amplifying an audio input signal comprising:
- an input supply voltage;
- an output stage; and,
- a controller coupled to the output stage;

wherein:
- the output stage is configured to be supplied in voltage by the input supply voltage;
- the output stage is configured to generate an audio output signal corresponding to an amplified version of the audio input signal;
- the output stage is a DC-DC converter;
- the controller is configured to receive the audio input signal; and,
- the controller is configured to generate one or more driving commands that are configured to drive the output stage in generating the audio output signal.

    An apparatus, wireless devices, the use of the audio amplifier and a method of amplifying an input signal are also claimed.

FIG. 3

## Description

### Technical Field

The proposed solution relates generally to amplifiers, and more especially to audio amplifiers.

It finds applications, in particular while not exclusively, in multimedia devices such as mobile phones, smartphones, tablets and portable console games.

### Background Art

The need to deliver a wide range of data hungry services such as audio and video to mobile users leads manufacturers to look for ways to develop versatile, high-quality audio functions, including high-output power amplifiers especially for portable and consumer electronics such as hearing-aids, multimedia players, notebook computers and wireless audio speakers.

Recently, audio designers have adopted for such purpose, amplifiers operating based on switching principles, called Class-D amplifiers, rather than those working with output transistors in linear mode such as Class-A or Class-AB amplifiers.

The major advantage of using Class-D amplifier stems from their high efficiency, wherein efficiency is an indicator of power performance of a device.

Namely, the more efficient a device is the less power it wastes or the less power it consumes overall.

Thus, an efficient Class-D amplifier leads to longer battery life and less heat generation.

For instance, a 90% efficient amplifier at 1 W output dissipates 100mW, while a 60% efficient amplifier with the same 1 W output consumes 400mW.

It is known that Class-D amplifiers can reach up to 95% of overall efficiency.

However, the high-speed switching in the output stage of Class-D amplifiers can be a powerful source of EMI (Electromagnetic interference) which can result in unacceptable radiations that may interfere with radio transmissions (e.g. GPS, Bluetooth, RF) and associated audio equipment, within a portable device for instance.

This is due to the fact that the output signal of a Class-D output stage is made of a sharp-edged rectangular signal with variable pulse widths, wherein rise times of the rectangular pulses are performed at a high frequency (e.g. between 5 ns to 40 ns).

Traditionally, an output filter, for instance, based on inductor is inserted between the Class-D output stage and a loudspeaker.

However today, most common applications are called filter-less whenever the reconstruction of the audio signal is done directly on the speaker itself since the latter comprises a high value inductor.

Also, additional filter based on ferrite beads may be used and mainly serves at preventing, the loudspeaker from becoming an effective antenna for spreading EMI emissions by filtering out the very high-frequency carrier and harmonics of the sharp-edged rectangular signal.

Unfortunately, this approach comes at a high cost in terms of required space for the output filter which cost money.

But its worst effect is that the output filter will only give a flat frequency response into one specific frequency area and can thus degrade audio performance of the amplified signal.

To summarize, providing an amplified audio signal with low EMI is not adequately addressed by known techniques.

### Summary of invention

Thus, an objective of the proposed solution is to alleviate the above problems by providing an audio amplifier wherein the output stage is a DC-DC converter.

A first aspect of the proposed solution relates to an audio amplifier for amplifying an audio input signal comprising:

- an input supply voltage;
- an output stage; and,
- a controller coupled to the output stage;

wherein:

- the output stage is configured to be supplied in voltage by the input supply voltage;
- the output stage is configured to generate an audio output signal corresponding to an amplified version of the audio input signal;

- the output stage is a DC-DC converter;
- the controller is configured to receive the audio input signal; and,
- the controller is configured to generate one or more driving commands that are configured to drive the output stage in generating the audio output signal.

A second aspect of the proposed solution relates to an apparatus comprising:

- the audio amplifier of the first aspect; and,
- an audio loudspeaker coupled to an output stage;

wherein the loudspeaker is configured to be driven by an audio output signal corresponding to an amplified version of an audio input signal.

A third aspect of the proposed solution relates to a wireless device comprising the audio amplifier of the first aspect.

A fourth aspect of the proposed solution relates to a wireless device comprising the apparatus of the second aspect.

A fifth aspect of the proposed solution relates to the use of the audio amplifier of the first aspect.

A sixth aspect of the proposed solution relates to a method of amplifying an audio input signal comprising the steps of:

- receiving one or more driving commands for driving an output stage, of an audio amplifier, in generating an audio output signal corresponding to an amplified version of the audio input signal;
- providing, at outputs of the output stage, the audio output signal based on at least the one or more driving commands;

wherein the output stage is a DC-DC converter.

Thus in a device embodying the principles of such mechanism, weaknesses of prior art regarding audio amplification with, for instance, Class-D amplifiers are overcome.

Namely, the proposed solution prevents the need of an output filter between an audio output stage and a loudspeaker in order to reduce or remove EMI emissions.

Indeed, the loudspeaker according to the proposed solution is driven by continuous signals generated by the proposed output stage instead of sharp-edged rectangular as it is the case in the prior art.

This way, with the proposed solution, electromagnetic compatibility (EMC) problems are assuaged.

Additionally, with the proposed solution, there is no more need of a boost converter between an input supply voltage and the audio output stage to provide a battery independent audio amplifier.

In fact, the proposed audio output stage may be a buck-boost DC-DC converter capable of stepping-up or stepping-down an input audio signal.

Also, a guaranteed output power, at the loudspeaker, can be delivered, independently from the discharge of the input supply voltage of the DC-DC output stage.

Another advantage of the proposed solution relates to the fact that, contrary to the know techniques, the operation of power conversion and amplification may be performed by a single compound structure.

In fact, in the prior art, an audio amplifier is connected directly to the battery or to a boost converter that regulates a static voltage to supply the amplifier, if a larger output power is targeted.

In contrast, in the proposed solution, a power converter regulates its output as an audio signal such that its output voltage depends on the amplitude of the audio signal.

Thus, with the proposed output stage, an audio input signal may be amplified by a given amplification gain at the loudspeaker and supply power for the audio amplifier may be provided by the proposed output stage as well.

In an embodiment, the one or more driving commands are based on at least the audio input signal and an amplification gain.

Advantageously, it may be permitted with the proposed solution to define and apply audio amplification scheme, for instance at the controller level, based on the driving commands.

In yet another embodiment, the one or more driving commands are further based on the audio output signal which is fed back to the controller.

The above embodiment may be contemplated if a feedback loop control for the audio amplification process is required.

In one embodiment, the one or more driving commands are square signals.

Possibly, the one or more driving commands are PWM signals.

Advantageously, regular PWM modulators may be used to generate the driving commands.

In another embodiment, wherein the output stage is a buck-boost DC-DC converter.

As explain above and hereinafter, using a buck-boost DC-DC converter as an audio output stage prevents the need of an additional boost converter, if a battery independent audio amplifier is needed.

In yet another embodiment, the output stage comprises two outputs coupled to two capacitors, configured to output the audio output signal and the audio output signal is a differential audio output signal.

Possibly, an instantaneous voltage of the differential audio output signal is set to 0 V when a voltage of 0 V is required for the audio output signal.

The latter embodiment demonstrates an improvement as compared to prior art Class-D amplifiers since it is no longer necessary to use a ternary modulation to represent the signal state where low input signals or no input signals is present at the input of the audio amplifier.

In an embodiment, the output stage comprises five power switches connected to an inductor and wherein:

- one power switch is connected to the input supply voltage;
- two power switches are connected to the ground
- two power switches are connected to the two outputs, respectively, of the output stage.

In one embodiment, the output stage is a buck DC-DC converter.

Such configuration may be needed if it is required only, at the loudspeaker, an output voltage lower than the input supply voltage.

For instance, the output stage comprises one output coupled to one capacitor, configured to output the audio output signal and the audio output signal is a single-ended audio output signal.

In an embodiment, the output stage comprises four power switches connected to an inductor and wherein:

- one power switch is connected to the input supply voltage;
- two power switches are connected to the ground
- one power switches is connected to the output, of the output stage.

**Brief description of drawings**

A more complete understanding of the proposed solution may be obtained from a consideration of the following description in conjunction with the drawings, in which like reference numbers indicate same or similar elements. In the drawings:

FIG. 1 is a block diagram illustrating a prior art implementation of a Class-D audio amplifier;

FIG. 2 is a block diagram illustrating an embodiment of an audio amplifier according to the proposed solution;

FIG. 3 is a block diagram illustrating a detailed embodiment of the proposed solution of FIG. 2;

FIG. 4 is a block diagram illustrating an embodiment of a PWM modulator;

FIG. 5 is a diagram illustrating an embodiment of a differential pair of output signals of the output stage of FIG. 3;

FIG. 6 is a block diagram illustrating an embodiment of a differential output stage according to the proposed solution;

FIG. 7 is a block diagram illustrating another prior art implementation of a class-D audio amplifier;

FIG. 8 is a flow diagram illustrating an embodiment of the proposed method;

FIG. 9 is a block diagram illustrating an embodiment of a single-ended output stage according to the proposed solution.

**Description of embodiments**

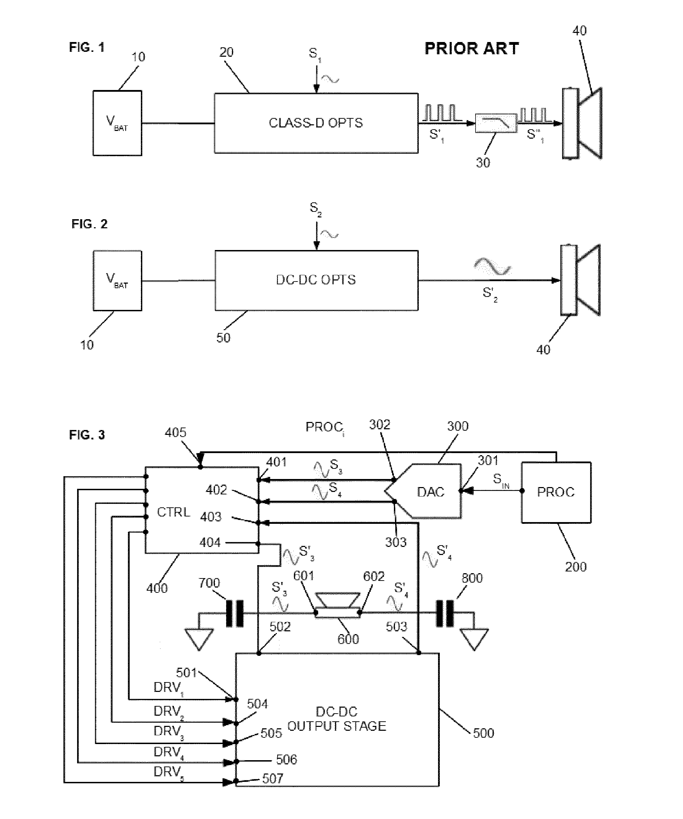

FIG. 1 is a block diagram illustrating schematically a prior art implementation of a Class-D audio amplifier.

The Class-D audio amplifier of FIG. 1 comprises an input supply voltage $V_{BAT}$, a Class-D output stage 20, an output filter 30 and an audio loudspeaker 40.

Referring to FIG.1, the Class-D output stage 20 may be configured to be supplied in voltage by the input supply voltage $V_{BAT}$.

Additionally, the Class-D output stage 20 may also be configured to amplify a first audio input signal $S_1$ thus creating a first output signal $S'_1$ at the output of the Class-D output stage 20.

As already explained above, the first output signal $S'_1$ of the Class-D output stage 20 is a sharp-edged rectangular output signal with a variable duty cycle relying on the principle of Pulse Width Modulation (PWM).

This is due to the fact that Class-D output stages are based on switching principles, as already explained above.

The first sharp-edged rectangular output signal $S'_1$ is then filtered by the output filter 30 in order to remove the very high-frequency carrier and harmonics of the sharp-edged rectangular output signal $S'_1$, thus producing the a first smooth-edged rectangular audio output signal $S''_1$. For instance, the output filter 30 may be a low pass filter.

The first smooth-edged rectangular audio output signal $S''_1$ may correspond to an amplified version of the first audio input signal $S_1$.

Finally, the first smooth-edged rectangular audio output signal $S''_1$ may be used to drive the audio loudspeaker 40.

As already stated in the introduction, the sharp-edged rectangular output signals generated by the Class-D output stage 20 can be a powerful source of electromagnetic interference (EMI) which can result in unacceptable EMI radiations that may interfere with radio transmissions (e.g. GPS, Bluetooth, RF) and associated audio equipment, within a portable, e.g. battery powered device, for instance.

This is why the output filter 30 may comprise ferrite beads and may be used to filter out the very high-frequency carrier and harmonics of the sharp-edged rectangular output signal $S'_1$ and thereby prevent EMI radiation from the Class-D output stage 20 of the Class-D amplifier.

Unfortunately, as explained above, the output filter 30 represents a high cost in terms of required space which cost money. In fact, even with filter-less solutions wherein the output filter is embedded into the speaker also requires, in any case, an output filter based on ferrite beads.

However, the worst effects of the output filter 30 lies on the fact that it provides a flat frequency response into one specific frequency area and can thus degrade audio performance of the amplified audio signal.

Embodiments of the proposed solution may be based on the fact that the output filter 30 is not necessary if the amplifier output stage can directly generates an amplified version of the first audio input signal $S_1$ that is continuous in shape instead of being rectangular in shape as it is the case in the prior art.

For instance, it has been found that a DC-DC converter may be used to replace the combination made of the Class-D output stage 20 and the output filter 30.

One of ordinary skill in the art of power conversion knows that a DC-DC converter is a circuit that has as primary feature to convert a Direct-Current (DC) voltage at the input terminals into another DC voltage at the output terminals.

According to the proposed solution, a DC-DC converter may be used as an output stage of an audio amplifier by directly delivering a voltage audio signal.

Therefore, based on the findings of the proposed solution, it is not necessary any more to use an output filter at one or more outputs of an audio output stage.

FIG. 2 is a block diagram illustrating schematically an embodiment of an audio amplifier according to the proposed solution.

The audio amplifier of FIG. 2 comprises an input supply voltage $V_{BAT}$, a DC-DC output stage 50 and an audio loudspeaker 40.

One should note that, as compared to the prior art of FIG. 1, there is no more need of an output filter 30.

Referring to FIG. 2, the DC-DC output stage 50 may be configured to be supplied in voltage by the input supply voltage $V_{BAT}$.

Additionally, the DC-DC output stage 50 may also be configured to amplify a second audio input signal $S_2$ thus creating a second continuous audio output signal $S'_2$ at the output of the Class-D output stage 20.

The second continuous audio output signal $S'_2$ may correspond to an amplified version of the second audio input signal $S_2$.

Finally, the second continuous audio output signal $S'_2$ may be used to drive the audio loudspeaker 40.

FIG. 3 is a block diagram illustrating schematically a detailed embodiment of the proposed solution of FIG. 2 which may be used to drive, for instance a loudspeaker 600 by generating an output signal, for instance an audio signal.

Referring to FIG.3, there is shown therein:

- a processor 200;
- a digital-to-analog converter 300;
- a controller 400;
- a DC-DC output stage 500; and,
- a loudspeaker 600.

The processor 200 may be configured to provide a digital input signal $S_{IN}$ to the digital-to-analog converter 300 via the input 301 of the digital-to-analog converter 300.

In another embodiment, the digital input signal $S_{IN}$ may be inputted to the digital-to-analog converter 300 via more than one inputs of the digital-to-analog converter 300.

One should note that the digital input signal $S_{IN}$ may be substantially equivalent to the second audio input signal $S_2$ of FIG. 2.

The digital input signal $S_{IN}$ may be, for instance, a series of digital bits and may be a digital representation of a signal such as an audio signal.

The digital-to-analog converter 300 may be configured to convert the digital input signal $S_{IN}$ into a differential pair of continuous input signals $S_3$, $S_4$.

In a variant, the digital-to-analog converter 300 may be configured to convert the digital input signal $S_{IN}$ into a single-ended continuous input signal.

The differential pair of continuous input signals $S_3$, $S_4$ may be outputted from the digital-to-analog converter 300 via the outputs 302 and 303.

In another embodiment, the differential pair of continuous input signals $S_3$, $S_4$ may be outputted from the digital-to-analog converter 300 via one or more than two outputs.

The differential pair of continuous input signals $S_3$, $S_4$ may be inputted to the controller 400 via the inputs 401 and 402, respectively.

In a variant, the differential pair of continuous input signals $S_3$, $S_4$ may be inputted via one or more than two inputs of the controller 400.

Referring to FIG. 3, the controller 400 may be configured to control the DC-DC output stage 500.

Namely, the controller 400 may be configured to control the generation by the DC-DC output stage 500 of a differential pair of continuous output signals $S'_3$, $S'_4$ corresponding to an amplified version of the differential pair of continuous input signals $S_3$, $S_4$.

The differential pair of continuous output signals $S'_3$, $S'_4$ may be inputted to the controller 400 via the inputs 403 and 404.

The above embodiment may be used to implement a feedback loop control of the amplification of the differential pair of continuous input signals $S_3$, $S_4$ based on at least the differential pair of continuous output signals $S'_3$, $S'_4$ and that may be controlled by the controller 400 as it will be described below.

In a variant, a single-ended output signal of the DC-DC output stage 500 may be inputted to the controller 400 via the input 403 or 404. Namely, in this variant only one of the input 403 or 404 of the controller 400 may be needed.

The above embodiment may be used to implement a feedback loop control of the amplification of the single continuous input sine-wave based on an amplified version of the differential pair of continuous input signals $S_3$, $S_4$, or a single-ended continuous input signal, that may be controlled by the controller 400.

Hereinafter, embodiments will be described with regard to a differential DC-DC output stage (i.e. the output stage comprises at least two outputs 502, 503).

However, it is also in the scope of the proposed solution to use, for instance, a single-ended DC-DC output stage wherein the output stage comprises only one output 502 or 503.

In order to control the DC-DC output stage 500, the controller 400 may send one or more driving commands $DRV_1$, $DRV_2$, $DRV_3$, $DRV_4$, $DRV_5$ to the DC-DC output stage 500 via the inputs 501, 504, 505, 506, 507.

In another embodiment, the driving commands $DRV_1$, $DRV_2$, $DRV_3$, $DRV_4$, $DRV_5$ may be inputted to the DC-DC output stage 500 via a single input 501, 504, 505, 506 or 507.

The driving commands $DRV_1$, $DRV_2$, $DRV_3$, $DRV_4$, $DRV_5$ may be, at least, based on processor commands $PROC_i$ and the differential pair of continuous input signals $S_3$, $S_4$.

In another embodiment wherein feedback loop control may be used, the driving commands $DRV_1$, $DRV_2$, $DRV_3$, $DRV_4$, $DRV_5$ may also be based on the differential pair of continuous output signals $S'_3$, $S'_4$.

Each driving command $DRV_1$, $DRV_2$, $DRV_3$, $DRV_4$, $DRV_5$ may comprise a PWM (Pulse Width Modulation) signal.

Thus, the controller 400 may comprise a PWM modulator in order to generate the PWM signals.

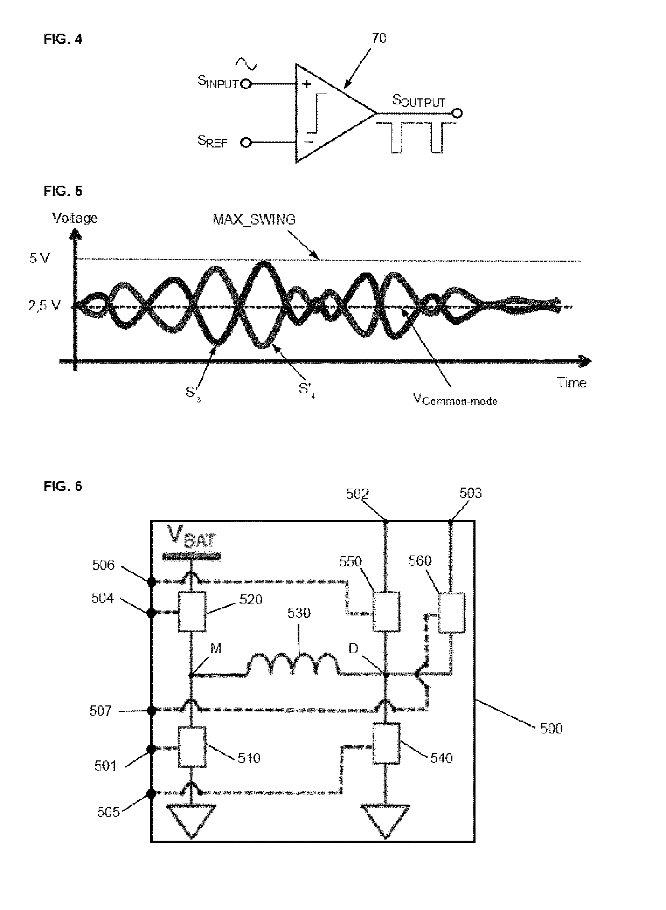

For instance, the PWM generation may be based on one or more comparators such as the one shown in FIG. 4. The comparators may be chained, for instance, in order to provide a predetermined PWM generation strategy that thus may be used to drive the DC-DC output stage 500.

In FIG. 4, there is shown therein a PWM modulator comprising a comparator 70.

In order to generate a PWM signal $S_{OUTPUT}$, an input signal $S_{INPUT}$ such as the differential pair of continuous input signals $S_3$, $S_4$, or part of it, may be applied to one side of a comparator 70 while a reference signal $S_{REF}$, such as a triangle or sawtooth signal may be applied on the other side of the comparator 70.

Then, whenever the input signal $S_{INPUT}$ is more positive than the reference signal $S_{REF}$, a positive pulse is produced that lasts as long as the input signal $S_{INPUT}$ is above a threshold set by the reference signal $S_{REF}$. Conversely, when the input signal $S_{INPUT}$ is below the threshold set by the reference signal $S_{REF}$, the output of the comparator 70 is a negative pulse that lasts as long as the input signal $S_{INPUT}$ is below a threshold set by the reference signal $S_{REF}$.

The output of the comparator is thus a rectangular signal $S_{OUTPUT}$ whose duty cycle corresponds to the amplitude of the input signal $S_{INPUT}$ voltage.

Hence, based on the above reasons, the driving commands $DRV_1$, $DRV_2$, $DRV_3$, $DRV_4$, $DRV_5$ may be understood as a way of applying a particular amplification scheme to the differential pair of continuous input signals $S_3$, $S_4$ in order to generate the differential pair of continuous output signals $S'_3$, $S'_4$.

In the field of audio amplification, such amplification scheme usually comprises defining an amplification gain to be applied to the differential pair of continuous input signals $S_3$, $S_4$.

This way, for instance, the instantaneous amplitude of the differential pair of continuous output signals $S'_3$, $S'_4$

may be equal to a product of the amplification gain with the instantaneous amplitude of the differential pair of continuous input signals $S_3$, $S_4$.

The amplification gain may correspond, for instance, to the ratio of, in one hand, the voltage difference between each of the differential pair of continuous input signals $S_3$, $S_4$ to, on the other hand, the voltage difference between each of the differential pair of continuous output signals $S'_3$, $S'_4$.

The required value of the amplification gain may be controlled by the processor 200 based on one or more processor commands $PROC_i$ sent, for instance, to the controller 400, via the input 405.

In a variant, the processor commands $PROC_i$ may be inputted to the controller 400 via more than one input.

Referring to FIG. 3, the DC-DC output stage 500 comprises five inputs 501, 504, 505, 506, 507 and two outputs 502, 503.

In the above embodiment, the DC-DC output stage 500 may be a differential output stage configured to output the differential pair of continuous output signals $S'_3$, $S'_4$ via the outputs 502, 503.

FIG. 5 is a diagram illustrating schematically an embodiment of the differential pair of continuous output signals $S'_3$, $S'_4$ of the output stage of FIG. 3.

Referring to Fig. 5, the differential pair of continuous output signals $S'_3$ and $S'_4$ are complementary.

In FIG. 5, there is shown therein the differential pair of continuous output signals $S'_3$ and $S'_4$ over time with corresponding amplitude referenced to a common-mode voltage set at 2.5 V.

As it can be noticed, each of the differential pair of continuous output signals $S'_3$ and $S'_4$ has the same voltage amplitude with opposite phase centred on the common-mode voltage.

FIG. 6 is a block diagram illustrating schematically an implementation of a differential DC-DC output stage according to the proposed solution.

In FIG. 6, the DC-DC output stage 500 may be supplied in voltage by an input supply voltage $V_{BAT}$.

As a non-limiting example, the voltage $V_{BAT}$ may, for example, be supplied by a battery of the device embodying the audio amplifier.

In FIG. 6, there is shown therein the DC-DC output stage 500 comprising one inductor 530 and five power switches 510, 520, 540, 550, 560 connected to the inductor 530.

The power switches 510, 520, 540, 550, 560 may be PMOS or NMOS power switches, for instance.

Referring to FIG. 6, the DC-DC output stage 500 may comprise two signal outputs 502, 503 configured to provide the differential pair of continuous output signals $S'_3$, $S'_4$.

In another embodiment, the DC-DC output stage 500 may comprise one signal output means to provide a single-ended continuous output signal.

In FIG. 6, the power switches 510, 520, 540, 550, 560 are connected to the inductor 503, the power switches 550 and 560 are further connected to the outputs 502 and 503 of the DC-DC output stage 500, respectively. Also, the power switches 510 and 540 are connected to a reference voltage common to the entire DC-DC output stage 500, commonly referred to as the ground with a value generally equal to 0 volt. Additionally, the power switch 520 is connected to the input supply voltage $V_{BAT}$.

In the shown example, the DC-DC output stage 500 is a double output buck-boost power stage which is configured to step-up or step-down the input supply voltage $V_{BAT}$ of the DC-DC output stage 500.

Further details regarding double-output buck-boost power stages can be found in:

- document (1): BELLONI, M., et al. On the design of single-inductor double-output DC-DC buck, boost and buck-boost converters. Electronics, Circuits and Systems, 2008. ICECS 2008. Aug. 31 2008-Sept. 3 2008, p.626- 629;
- document (2): WEIWE, Xu, et al. A 90% peak efficiency single-inductor dual-output buck-boost converter with extended-PWM control. Solid-State Circuits Conference Digest of Technical Papers (ISSCC), 2011. 20-24 Feb. 2011, p.394-396; and,
- document (3): HUANG, Ming-Hsin, et al. Single-inductor dual buck-boost output (SIDBBO) converter with adaptive current control mode (ACCM) and adaptive body switch (ABS) for compact size and long battery life in portable devices. VLSI Circuits, 2009. 16-18 June 2009, p.164-165, for instance.

One advantage of using a buck-boost power stage as an audio amplifier is that it provides an audio amplifier that is battery independent.

Hence, for instance, the voltage of the differential pair of continuous output signals $S'_3$, $S'_4$ may be independent from the remaining input supply voltage $V_{BAT}$, during a discharge cycle of the input supply voltage $V_{BAT}$.

Therefore a weakness of audio amplification with Class-D amplifiers providing an output power to the loudspeaker 170 which is reducing as the input supply voltage $V_{BAT}$ reduces is overcome with the proposed solution based on the use of a buck-boost power stage as an audio output stage.

One should note that this result contrast with prior art approaches of Class-D amplifiers since the output voltage is no longer dependent on the available input voltage with the proposed solution.

In fact, most Class-D amplifiers are limited in output power by the voltage level of their power supply.

Therefore, in a device such as a mobile phone, for instance, where the battery gets discharged between two battery charge cycles, the output power delivered by a loudspeaker may reduce significantly in the absence of specific measures being taken.

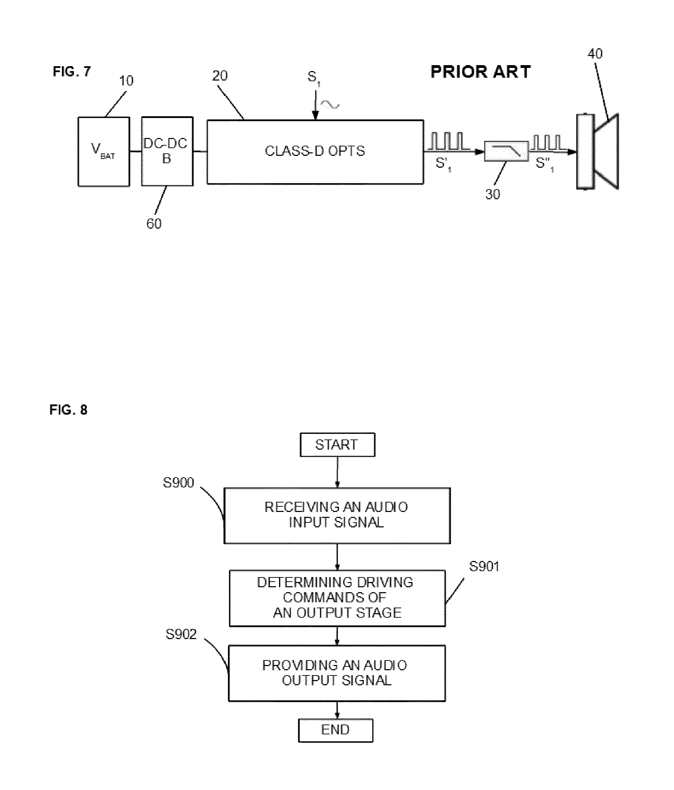

One workaround to this problem, in the prior art, consists in using a boost converter as it is illustrated in FIG. 7 which is 7 is a block diagram illustrating another prior art implementation of a class-D audio amplifier based on components already described above for FIG. 1.

Referring to FIG. 7, the boost converter 60 may be placed between the input supply voltage $V_{BAT}$ and the Class-D output stage 20.

In FIG.7, the boost converter 60 may be used to step-up the input supply voltage $V_{BAT}$ such that a desired output power may be delivered at the output of the Class-D output stage 20 even when the input power supply reduces. For instance, a boost type DC/DC converter may be used for such purpose.

Unfortunately, this approach comes at a high cost in terms of required silicon area for the boost converter 60 on the PCB and also in terms of energy required by the boost converter 60 on a device where autonomy may be already limited.

With the findings of the proposed solution, there is no more need of a boost converter 60 between the input supply voltage $V_{BAT}$ and the Class-D output stage 20.

This is due to the fact that the proposed DC-DC output stage 500 may be a double output buck-boost power stage which may be configured to step-up or step-down the input supply voltage $V_{BAT}$ of the DC-DC output stage 500, independently of the input supply voltage $V_{BAT}$.

Referring back to FIG. 6, it will be noted that, at nodes M of the DC-DC output stage 500, the voltage may be either at the input supply voltage $V_{BAT}$ or at a reference voltage common to the entire DC-DC output stage 500, commonly referred to as the ground with a value generally equal to 0 volt.

Therefore at nodes M and D, sharp-edged rectangular signals, as shown in FIG. 1, are available.

One of the effects of the inductor 530 on these sharp-edged rectangular signals available either at point M or D may be to smooth currents of the corresponding rectangular signals.

Referring to FIG. 3 and FIG. 6, the signals available at the outputs 502 and 503, of the DC-DC output stage 500, are at the same potential as the capacitors 700 and 800, respectively.

One of the effects of the capacitors 700, 800 on the signals available at the outputs 502 and 503 of the output stage may be to smooth their voltages by forcing signal continuity in voltage.

Hence, the combination of the inductor 630 and the capacitor 700, 800 creates a LC filter which purpose may be to smooth in voltage the differential pair of continuous output signals $S'_3$ and $S'_4$.

Therefore, at the inputs 601 and 602 of the loudspeaker 600, each of the differential pair of continuous output signals $S'_3$ and $S'_4$ has a continuous shape.

This is one major difference with prior art approaches where sharp-edged rectangular signals were generated at the output the output stage and were then further filtered via an output filter before being supplied to the loudspeaker 600.

In contrast, in the proposed solution, a differential pair of continuous output signals $S'_3$, $S'_4$ may be directly supplied to the supply rails 601, 602 of the loudspeaker 600, respectively, out of the DC-DC output stage 500.

This principle has, at least, one impact on the design of an audio amplifier, according to the proposed solution.

In fact, with the findings of the invention, it is no longer necessary to use low pass filters (LPFs) for instance based on ferrite beads to filter out the very high-frequency of a rectangular signal and its harmonics to prevent EMI radiation from the amplifier.

In fact, contrary to the prior art, continuous signals are outputted from the proposed output stage instead of sharp-edged rectangular signals.

Further to this, in the case of an audio amplifier, for instance, the differential pair of continuous output signals $S'_3$, $S'_4$ may be an audio signal that may be mainly generated in the audio band (i.e. from 20 Hz to 20 kHz) and with a low amplitude harmonics in the high frequency band (i.e. above 1 MHz).

This solution does not require any LPF, for instance based on ferrite beads, and as the effect of at least reducing or eliminating any electromagnetic interference (EMI) and that occurs in the very high frequency bandwidth that may be generated by an amplifier according to the proposed solution.

Therefore, the drawback of audio amplification with Class-D amplifiers necessitating the use of output filters to reduce EMI radiation is overcome with the proposed solution.

Another advantage of the proposed solution using a buck-boost power stage as an audio amplifier may be that the buck-boost power stage may comprise more than one output.

For instance, in FIG. 6, there is shown therein an output stage 500 comprising two outputs 502 and 503, such that a differential audio signal may be outputted from the output stage 500 directly to the audio loudspeaker 600.

Referring to FIG. 6, the power switches 510, 520, 540, 550, 560 may be configured to be controlled by the driving commands $DRV_1$, $DRV_2$, $DRV_3$, $DRV_4$, $DRV_5$ as described above.

The driving commands $DRV_1$, $DRV_2$, $DRV_3$, $DRV_4$, $DRV_5$ may be configured, respectively, to turn on or turn off power switches 510, 520, 540, 550, 560 via the five signal inputs 501, 504, 505, 506, 507, respectively.

This may be done by applying a particular amplification scheme, to the output stage 500, defined by the controller 400 in response to one or more processor commands $PROC_i$ received from the processor 200.

One should understand that, throughout the description, when a power switch 510, 520, 540, 550, 560 is said to be "turned on" it means that corresponding switch 510, 520, 540, 550, 560 is "closed" and conducting, such that current can flow through it.

On the other hand, when a power switch 510, 520, 540, 550, 560, is said to be "turned off" it means that corresponding switch 510, 520, 540, 550, 560 is "open" and non-conducting, such that current cannot flow through it.

The driving commands $DRV_1$, $DRV_2$, $DRV_3$, $DRV_4$, $DRV_5$ may be also configured to define a common-mode voltage of the DC-DC output stage 500 so as to generate the differential pair of continuous output signals $S'_3$, $S'_4$ which voltage may be generated based on, at least, a reference to the common-mode voltage.

In a single-ended variant of the proposed solution, the single-ended continuous output signal may not need to be based on the common-mode voltage.

Based on the common-mode voltage, each of the differential pair of continuous output signals $S'_3$, $S'_4$ has the same voltage amplitude with opposite polarity and both are applied simultaneously in parallel to the loudspeaker 600.

As explained above, signals $S'_3$ and $S'_4$ are complementary.

Namely each of the differential pair of continuous output signals $S'_3$, $S'_4$ has the same voltage amplitude and opposite phase centred around the common-mode voltage as it is illustrated in FIG. 4,.

Therefore, the output voltage of, for instance, an audio signal, at it is seen by the loudspeaker 600 at a specific moment in time may be equal to the difference between the instantaneous voltages of each of the differential pair of continuous output signals $S'_3$, $S'_4$ as expressed by the following formula:

$$V_{speaker} = S'_{3\_instantaneous\_voltage} - S'_{4\_instantaneous\_voltage} \quad (1)$$

with:

$$S'_{3\_instantaneous\_voltage} = V_{common\_mode} + (V_{speaker}/2) \quad (2);$$

and,

$$S'_{4\_instantaneous\_voltage} = V_{common\_mode} - (V_{speaker}/2) \quad (3);$$

wherein:

- $V_{speaker}$ is the output voltage as it is seen by the loudspeaker 600;
- $S'_{3\_instantaneous\_voltage}$ is the instantaneous voltage of $S'_3$;
- $S'_{4\_instantaneous\_voltage}$ is the instantaneous voltage of $S'_4$; and,
- $V_{common\_mode}$ is the common-mode voltage.

The common-mode voltage may be defined with reference to the maximum voltage that can be outputted by the output stag 500.

For instance, the common-mode voltage may be expressed as being half of the maximum output voltage that can be generated by the DC-DC output stage 500, also called maximum voltage swing MAX_SWING.

For instance, referring to FIG. 5, when the maximum voltage swing MAX_SWING of the DC-DC output stage 500 is 5 volts, then the common voltage for the differential pair of continuous output signals $S'_3$, $S'_4$ may be 2.5 volts (i.e. 2.5 = 5/2).

Therefore, one of the tasks of the DC-DC output stage 500, in order to provide the differential output signal to the loudspeaker 600 with a required output voltage $V_{speaker}$ may be to determine the required instantaneous voltage $S'_{3\_instantaneous\_voltage}$ and $S'_{4\_instantaneous\_voltage}$, to set them to opposite polarities.

In order to determine the required instantaneous voltage $S'_{3\_instantaneous\_voltage}$, $S'_{4\_instantaneous\_voltage}$, one can simply use the formulas (2) or (3) as described above.

For example, if the required output $V_{speaker}$ at the loudspeaker 600 is 1 V then the required instantaneous voltage S'$_{3\_instantaneous\_voltage}$, S'$_{4\_instantaneous\_voltage}$ may be equal to V$_{common\_mode}$ +/- 0.5 volts (i.e. 0.5 = 1/2) according to formula (2) or (3).

In the same way, if the required output V$_{speaker}$ at the loudspeaker 600 is 2.5 volts, then the required instantaneous voltage S'$_{3\_instantaneous\_voltage}$, S'$_{4\_instantaneous\_voltage}$ may be equal to V$_{common\_mode}$ +/- 1.25 volts (i.e. 1.25 = 2.5/2) according to above formula (2) or (3).

In another example, if the required output V$_{speaker}$ at the loudspeaker 600 is 0 V then the required instantaneous voltage S'$_{3\_instantaneous\_voltage}$, S'$_{4\_instantaneous\_voltage}$ may be equal to V$_{common\_mode}$ +/- 0 V (i.e. 0 = 0/2) according to formula (2) or (3).

The latter example demonstrates an improvement as compared to conventional Class-D amplifiers.

In fact, with the proposed solution it is no longer necessary to use ternary modulation as it is used in conventional Class-D amplifiers, such that it is no longer necessary to have currents flowing out of the audio amplifier when no input signals is present at the input of the amplifier.

Namely, with conventional Class-D amplifiers, it is required to set the differential pair of rectangular output signals at the same polarity (i.e. both high or both low) in order to represent the state where low input signals or no input signals is present at the input of the amplifier.

Hence, for instance, in a common class-D amplifier with an output stage having a maximum voltage swing of 5V, the zero state of the ternary modulation may be represented by setting the differential pair of rectangular output signals with same polarity and same amplitude at 5V.

This prior art approach definitively still consumes energy even when no signal is to be outputted from the Class-D amplifier.

In fact, with the ternary modulation the output stage of the prior art is still switching, thus consuming amount of power due mainly to switching losses.

Contrary to this approach, the DC-DC output stage 500 of the proposed solution may be capable of delivering the differential pair of continuous output signals S'$_3$, S'$_4$ with a voltage of 0 volt.

In fact, as already mentioned in the above, the DC-DC output stage 500 may be a buck-boost power stage configured to deliver independent positive output voltages, to each of the differential pair of continuous output signals S'$_3$, S'$_4$ that can be higher or lower than the input supply voltage V$_{BAT}$ of the DC-DC output stage 500.

Further to this, one should note that the voltages of each of the differential pair of continuous output signals S'$_3$, S'$_4$ may be higher or lower than the other one.

FIG. 8 is a flow diagram illustrating an embodiment of the proposed method of amplifying an input signal.

Referring to FIG. 8, in step S900, it is received at the input of an audio amplifier according to the proposed solution, a differential pair of continuous input signals S$_3$, S$_4$ as already described above.

This operation may be performed based on the collaboration, for instance of the processor 200, the digital-to-analog converter 300 and the controller 400 as already described above.

Then, in a step S901, it is calculated and received at the input of the DC-DC output stage 500, of the audio amplifier, at least one driving command DRV$_1$, DRV$_2$, DRV$_3$, DRV$_4$, DRV$_5$ in order to drive the DC-DC output stage in amplifying the differential pair of continuous input signals S$_3$, S$_4$ as already described above.

The operation of calculating and generating the driving commands DRV$_1$, DRV$_2$, DRV$_3$, DRV$_4$, DRV$_5$ may be performed, for instance in the controller 400.

As already explained above, the driving commands DRV$_1$, DRV$_2$, DRV$_3$, DRV$_4$, DRV$_5$ may be used to drive the DC-DC output stage 500 by applying a predefined amplification scheme to each of the differential pair of continuous input signals S$_3$, S$_4$ for instance, based on a common-mode voltage.

Later, in a step S902, a differential pair of continuous output signals S'$_3$, S'$_4$ corresponding to an amplified version of the differential pair of continuous input signals S$_3$, S$_4$ is provided based on, at least, the driving commands DRV$_1$, DRV$_2$, DRV$_3$, DRV$_4$, DRV$_5$ and the differential pair of continuous input signals S$_3$, S$_4$, as already explained above.

The differential output may then be used, for instance, to drive the supply rails 601, 602 of a loudspeaker 600.

After that, the algorithm may stop.

The proposed solution enables to overcome weaknesses of prior art regarding audio amplification with, for instance, Class-D amplifiers.

Namely, the proposed solution prevents the need of an output filter between the audio output stage and the loudspeaker in order to reduce or remove EMI emissions.

This way, with the proposed solution, electromagnetic compatibility (EMC) problems are assuaged.

Additionally, with the proposed solution, there is no more need of a boost converter between an input supply voltage and the audio output stage to provide a battery independent audio amplifier.

Also, a guaranteed output power can be delivered, independently from the discharge of the input supply voltage V$_{BAT}$ of the DC-DC output stage 500, by a load such as the loudspeaker 600 connected to the power stage 500.

Although the proposed solution is described above in terms of various exemplary embodiments and implementations, it should be understood that the various features, aspects and functionality described in one or more of the individual embodiments are not limited in their applicability to the particular embodiment with which they are described, but instead can be applied, alone or in various combinations, to one or more of the other embodiments of the proposed solution, whether or not such embodiments are described and whether or not such features are presented as being a part of a described embodiment. Thus, the breadth and scope of the present proposed solution should not be limited by any of the above-described exemplary embodiments.

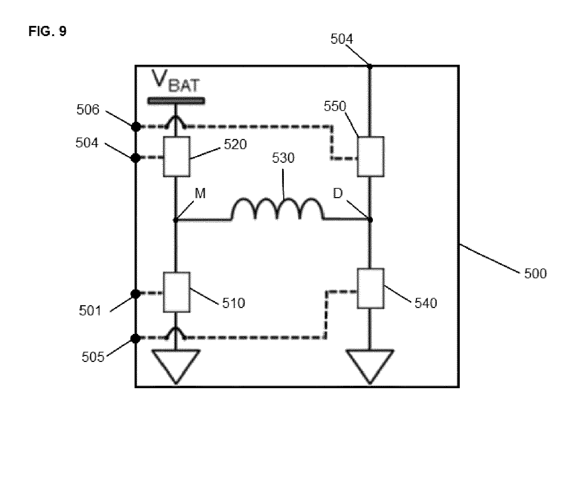

For instance, as already explained above a single-ended DC-DC audio output stage, as illustrated in FIG. 9 with the single output 504, may have been used instead of the differential DC-DC audio output stage 500 as already described above for FIG. 6.

FIG. 9 is a block diagram illustrating an embodiment of a single-ended output stage according to the proposed solution and which comprises substantially the same components as already described above for FIG. 6.

In the above case, for instance, a Buck DC-DC audio output stage may be used.

Also, the proposed solution has also been presented while mainly considering inductive type DC-DC output stages.

However, it is also in the scope of the proposed solution to use, for instance, DC-DC output stages based on linear voltage converters or based on capacitor charge-pumps.

Terms and phrases used in this document, and variations thereof, unless otherwise expressly stated, should be construed as open ended as opposed to limiting. As examples of the foregoing: the term "including" should be read as meaning "including, without limitation" or the like; the term "example" is used to provide exemplary instances of the item in discussion, not an exhaustive or limiting list thereof; the terms "a" or "an" should be read as meaning "at least one," "one or more" or the like; and adjectives such as "conventional," "traditional," "normal," "standard," "known" and terms of similar meaning should not be construed as limiting the item described to a given time period or to an item available as of a given time, but instead should be read to encompass conventional, traditional, normal, or standard technologies that may be available or known now or at any time in the future. Likewise, where this document refers to technologies that would be apparent or known to one of ordinary skill in the art, such technologies encompass those apparent or known to the skilled artisan now or at any time in the future.

The presence of broadening words and phrases such as "one or more, least," "but not limited to" or other like phrases in some instances shall not be read to mean that the narrower case is intended or required in instances where such broadening phrases may be absent. Additionally, the various embodiments set forth herein are described in terms of exemplary block diagrams, flow charts and other illustrations. As will become apparent to one of ordinary skill in the art after reading this document, the illustrated embodiments and their various alternatives can be implemented without confinement to the illustrated examples. These illustrations and their accompanying description should not be construed as mandating a particular architecture or configuration.

## Reference documents list

**Document (1):** BELLONI, M., et al. On the design of single-inductor double-output DC-DC buck, boost and buck-boost converters. Electronics, Circuits and Systems, 2008. ICECS 2008. Aug. 31 2008-Sept. 3 2008, p.626- 629.

**Document (2):** WEIWE, Xu, et al. A 90% peak efficiency single-inductor dual-output buck-boost converter with extended-PWM control. Solid-State Circuits Conference Digest of Technical Papers (ISSCC), 2011. 20-24 Feb. 2011, p.394-396.

**Document (3):** HUANG, Ming-Hsin, et al. Single-inductor dual buck-boost output (SIDBBO) converter with adaptive current control mode (ACCM) and adaptive body switch (ABS) for compact size and long battery life in portable devices. VLSI Circuits, 2009. 16-18 June 2009, p.164-165.

## Claims

**1.** An audio amplifier for amplifying an audio input signal ($S_2$, $S_3$, $S_4$) comprising:

- an input supply voltage ($V_{BAT}$);
- an output stage (500); and,
- a controller (400) coupled to the output stage;

wherein:

- the output stage is configured to be supplied in voltage by the input supply voltage;
- the output stage is configured to generate an audio output signal corresponding to an amplified version of the audio input signal;

- the output stage is a DC-DC converter (50);
- the controller is configured to receive the audio input signal; and,
- the controller is configured to generate one or more driving commands ($DRV_1$, $DRV_2$, $DRV_3$, $DRV_4$, $DRV_5$) that are configured to drive the output stage in generating the audio output signal.

2. The audio amplifier of claim 1 wherein the one or more driving commands are based on at least the audio input signal and an amplification gain.

3. The audio amplifier of claim 2 wherein the one or more driving commands are further based on the audio output signal which is fed back to the controller.

4. The audio amplifier of any one of claims 1 to 3, wherein the one or more driving commands are square signals.

5. The audio amplifier of claims 4, wherein the one or more driving commands are PWM signals.

6. The audio amplifier of any one of claims 1 to 5, wherein the output stage is a buck-boost DC-DC converter.

7. The audio amplifier of claim 6, wherein:

   - the output stage comprises two outputs (502, 503) coupled to two capacitors (700, 800) and configured to output the audio output signal; and,
   - the audio output signal is a differential audio output signal.

8. The audio amplifier of claim 7, wherein an instantaneous voltage of the differential audio output signal is set to 0 V when a voltage of 0 V is required for the audio output signal.

9. The audio amplifier of any one of claims 6 to 8, wherein the output stage comprises five power switches (510, 520, 540, 550, 560) connected to an inductor (530) and wherein:

   - one power switch (520) is connected to the input supply voltage ($V_{BAT}$);
   - two power switches (510, 540) are connected to the ground
   - two power switches (550, 560) are connected to the two outputs (502, 503), respectively, of the output stage.

10. The audio amplifier of any one of claims 1 to 5, wherein the output stage is a buck DC-DC converter.

11. The audio amplifier of claim 10, wherein:

    - the output stage comprises one output (504) coupled to one capacitor (700, 800) and configured to output the audio output signal; and,
    - the audio output signal is a single-ended audio output signal.

12. The audio amplifier of any one of claims 10 to 11, wherein the output stage comprises four power switches (510, 520, 540, 550) connected to an inductor (530) and wherein:

    - one power switch (520) is connected to the input supply voltage ($V_{BAT}$);
    - two power switches (510, 540) are connected to the ground
    - one power switches (550) is connected to the output (502), of the output stage.

13. An apparatus comprising:

    - an audio amplifier according to any one of claims 1 to 12; and,
    - an audio loudspeaker (600) coupled to an output stage;
    wherein the loudspeaker is configured to be driven by an audio output signal ($S'_2$, $S'_3$, $S'_4$) corresponding to an amplified version of an audio input signal.

14. A wireless device comprising an amplifier according to any one of claims 1 to 12.

15. A wireless device comprising an apparatus according to claim 13.

**16.** Use of the audio amplifier of any one of claims 1 to 12 for amplifying an audio input signal ($S_2$, $S_3$, $S_4$) wherein the amplified version of the audio input signal is at least one of the group of single-ended audio output signal or differential audio output signal ($S'_3$, $S'_4$).

**17.** A method of amplifying an audio input signal comprising the steps of:

- receiving one or more driving commands ($DRV_1$, $DRV_2$, $DRV_3$, $DRV_4$, $DRV_5$) for driving an output stage (500), of an audio amplifier, in generating an audio output signal ($S'_2$, $S'_3$, $S'_4$) corresponding to an amplified version of the audio input signal;
- providing, at outputs (502, 503, 504) of the output stage, the audio output signal based on at least the one or more driving commands;
wherein the output stage is a DC-DC converter.

**18.** The method of claim 17, wherein the output stage is a double-output buck-boost DC-DC converter.

EP 2 768 136 A1

**FIG. 1**  10  20  S₁  **PRIOR ART**  40

V_BAT ── CLASS-D OPTS ──| S'₁ ──[30]── S"₁ ──▷ 40

**FIG. 2**  S₂

V_BAT ── DC-DC OPTS ────── S'₂ ──▷ 40

10  50  10  40

**FIG. 3**  405  PROC_i  302  300

401 S₃  402 S₄  DAC  301 S_IN  PROC
CTRL 403  303  200
404 S'₃  S'₄

700 S'₃  601 602 S'₄  800
600
502  503

501
DRV₁  504
DRV₂  DC-DC
DRV₃  505 OUTPUT STAGE  500
DRV₄  506
DRV₅  507

14

**FIG. 4**

S_INPUT

70

S_OUTPUT

S_REF

**FIG. 5**

Voltage

MAX_SWING

5 V

2,5 V

Time

S'₃        S'₄        V_Common-mode

**FIG. 6**

502        503

V_BAT

506

550        560

504

520

530

M        D

507

510        540

501

500

505

**FIG. 7**  10  20  S,  **PRIOR ART**  40

| V_BAT | DC-DC B | CLASS-D OPTS | S'_1 | | S"_1 |

60  30

**FIG. 8**

START

S900  RECEIVING AN AUDIO
INPUT SIGNAL

DETERMINING DRIVING
COMMANDS OF
AN OUTPUT STAGE  S901

S902  PROVIDING AN AUDIO
OUTPUT SIGNAL

END

FIG. 9

Europäisches
Patentamt

European
Patent Office

Office européen
des brevets

# EUROPEAN SEARCH REPORT

Application Number

EP 13 30 5168

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 02/093973 A1 (BANG & OLUFSEN ICEPOWER AS [DK]; NIELSEN KARSTEN [DK]) 21 November 2002 (2002-11-21) * page 10, line 9 - page 11, line 25; figures 5,6,7,8 * | 1-4,13, 16,17 | INV. H03F3/217 |
| X | US 8 093 951 B1 (ZHANG LINGLI [US] ET AL) 10 January 2012 (2012-01-10) * the whole document * | 1,2, 13-17 | |
| X | EP 1 271 766 A2 (FLYING MOLE CORP [JP]) 2 January 2003 (2003-01-02) * the whole document * | 1-4,16, 17 | |
| X | US 6 266 425 B1 (FUJISAWA MASANORI [JP] ET AL) 24 July 2001 (2001-07-24) * the whole document * | 1,2,4,5, 13,16,17 | |
| X | ERTL H ET AL: "Basic considerations and topologies of switched-mode assisted linear power amplifiers", APPLIED POWER ELECTRONICS CONFERENCE AND EXPOSITION, 1996. APEC '96. C ONFERENCE PROCEEDINGS 1996., ELEVENTH ANNUAL SAN JOSE, CA, USA 3-7 MARCH 1996, NEW YORK, NY, USA,IEEE, US, vol. 1, 3 March 1996 (1996-03-03), pages 207-213, XP010159754, DOI: 10.1109/APEC.1996.500444 ISBN: 978-0-7803-3044-3 * the whole document * | 1,2,4, 13,16,17 | TECHNICAL FIELDS SEARCHED (IPC) H03F |
| A | US 5 506 493 A (STENGEL ROBERT E [US]) 9 April 1996 (1996-04-09) * the whole document * | 1-5, 13-17 | |

-/--

~~The present search report has been drawn up for all claims~~

| Place of search | Date of completion of the search | Examiner |
|---|---|---|
| Munich | 18 July 2013 | Kurzbauer, Werner |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

 

& : member of the same patent family, corresponding
 document

EPO FORM 1503 03.82 (P04C01)

Europäisches
Patentamt

European
Patent Office

Office européen
des brevets

## EUROPEAN SEARCH REPORT

Application Number

EP 13 30 5168

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHENFEI PENG ET AL: "An 80% peak efficiency, 410mW, single supply rail powered Class-I linear audio amplifier", CUSTOM INTEGRATED CIRCUITS CONFERENCE (CICC), 2011 IEEE, IEEE, 19 September 2011 (2011-09-19), pages 1-4, XP032063843, DOI: 10.1109/CICC.2011.6055395 ISBN: 978-1-4577-0222-8 * the whole document * | 1-5, 13-17 | |
| A | US 6 496 059 B1 (NGUYEN TRANH T [US]) 17 December 2002 (2002-12-17) * the whole document * | 1-5, 13-17 | |

TECHNICAL FIELDS
SEARCHED       (IPC)

~~The present search report has been drawn up for all claims~~

| Place of search | Date of completion of the search | Examiner |
|---|---|---|
| Munich | 18 July 2013 | Kurzbauer, Werner |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

Application Number

EP 13 30 5168

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-5, 13-17

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

1. claims: 1-5, 13-17

    An audio amplifier comprising a controller coupled to an output stage; wherein the output stage is a DC-DC converter and the controller is configured to receive the audio input signal and is to generate one or more driving commands for the output stage wherein the one or more driving commands are further based on the audio output signal which is fed back to the controller.

    ---

2. claims: 6-9, 18

    An audio amplifier comprising a controller coupled to an output stage; wherein the output stage is a DC-DC converter and the controller is configured to receive the audio input signal and is to generate one or more driving commands for the output stage, wherein the output stage is a buck-boost DC-DC converter.

    ---

3. claims: 10-12

    An audio amplifier comprising a controller coupled to an output stage; wherein the output stage is a DC-DC converter and the controller is configured to receive the audio input signal and is to generate one or more driving commands for the output stage, wherein the output stage is a buck DC-DC converter.

    ---

## ANNEX TO THE EUROPEAN SEARCH REPORT
## ON EUROPEAN PATENT APPLICATION NO.

EP 13 30 5168

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2013

| Patent document cited in search report | | Publication date | Patent family member(s) | | Publication date |
|---|---|---|---|---|---|
| WO 02093973 | A1 | 21-11-2002 | AU 2002302881 | B2 | 28-07-2005 |
| | | | CA 2445463 | A1 | 21-11-2002 |
| | | | CN 1509583 | A | 30-06-2004 |
| | | | EP 1391137 | A1 | 25-02-2004 |
| | | | JP 2005508105 | A | 24-03-2005 |
| | | | KR 20040004607 | A | 13-01-2004 |
| | | | US 2004161122 | A1 | 19-08-2004 |
| | | | WO 02093973 | A1 | 21-11-2002 |
| US 8093951 | B1 | 10-01-2012 | NONE | | |
| EP 1271766 | A2 | 02-01-2003 | EP 1271766 | A2 | 02-01-2003 |
| | | | JP 3499225 | B2 | 23-02-2004 |
| | | | JP 2003008366 | A | 10-01-2003 |
| | | | US 2002190792 | A1 | 19-12-2002 |
| US 6266425 | B1 | 24-07-2001 | CN 1253413 | A | 17-05-2000 |
| | | | KR 20000035196 | A | 26-06-2000 |
| | | | TW 469689 | B | 21-12-2001 |
| | | | US 6266425 | B1 | 24-07-2001 |
| US 5506493 | A | 09-04-1996 | NONE | | |
| US 6496059 | B1 | 17-12-2002 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BELLONI, M. et al.** On the design of single-inductor double-output DC-DC buck, boost and buck-boost converters. *Electronics, Circuits and Systems, 2008. ICECS 2008,* 31 August 2008, 626-629
- **WEIWE, XU et al.** A 90% peak efficiency single-inductor dual-output buck-boost converter with extended-PWM control. *Solid-State Circuits Conference Digest of Technical Papers (ISSCC),* 20 February 2011, 394-396

- **HUANG, MING-HSIN et al.** Single-inductor dual buck-boost output (SIDBBO) converter with adaptive current control mode (ACCM) and adaptive body switch (ABS) for compact size and long battery life in portable devices. *VLSI Circuits,* 16 June 2009, 164-165